# EUROPEAN PATENT APPLICATION

(11) **EP 4 397 992 A1**
(43) Date of publication of application: **10.07.2024**
(21) Application number: 23150189.1
(22) Date of filing: 03.01.2023
(51) Int. Cl.: G01S 7/4863, G01S 7/51, G01S 17/18, H01L 27/146

(54) **SOLID-STATE OPTICAL SENSOR AND DEVICE FOR MEASURING A DISTANCE COMPRISING SAID SENSOR**

(71) Applicant: SICK AG, 79183 Waldkirch (DE); Fondazione Bruno Kessler, 38122 Trento (IT)
(72) Inventor: Zwölfer, Ulrich, 79183 Waldkirch (DE); Albert, Michael, 77955 Ettenheim (DE); Götz, Matthias, 79104 Freiburg (DE); Tontini, Alessandro, Caldonazzo (TN) (IT); Massari, Nicola, Pergine Valsugana (TN) (IT); Perenzoni, Matteo, Rovereto (TN) (IT); Gasparini, Leonardo, Pergine Valsugana (TN) (IT)

(57) **Abstract**

Solid-state optical sensor (10) configured to detect the incidence of one or more photons of a light radiation (R) during an acquisition window (Ta), comprising:
- a silicon plate (11) having a sensitive surface (11a) configured to detect the incidence of one or more photons of said light radiation (R) and comprising a plurality of photosensitive microcells (12a, 12b, 12c), each microcell being adapted to generate an electrical detection signal (Ua, Ub, Uc) when a photon is detected;
- a control unit (14) configured to acquire said electrical detection signals (Ua, Ub, Uc) in input;
and configured to perform the following operating steps:
a) activating at least one microcell of said plurality of photosensitive microcells (12a, 12b, 12c) at the beginning of said acquisition window (Ta) while keeping the remaining microcells inactive;
b) waiting for the generation of one of said electrical detection signals (Ua, Ub, Uc) by said at least one active microcell;
c) activating at least one different inactive microcell by means of an electrical enable signal (Ea, Eb, Ec) when one of said electrical detection signals (Ua, Ub, Uc) has been generated;
d) repeating steps b) and c) for the duration of said acquisition window (Ta).

## Description

The invention concerns a solid-state optical sensor. The invention also relates to a measuring device comprising such a solid-state optical sensor.

Solid-state sensors capable of detecting the incidence of one or more photons of light radiation are now known. Such a sensor of known type comprises a surface sensitive to light radiation, configured to detect such photons. This sensitive surface in turn comprises a plurality of photosensitive microcells, each of which is adapted to generate an electrical detection signal when a photon is detected. Furthermore, such a sensor also comprises a control unit configured to acquire such electrical detection signals in input.

Such a solid-state optical sensor, although known and appreciated, has an important limitation linked to a distortion phenomenon that occurs when detecting light radiations. In particular, the photosensitive microcells of such a sensor have very high gains compared, for example, to the photosensitive microcells typically employed for making image sensors. This allows generating a macroscopic electrical detection signal following the detection of a photon by a similar microcell.

However, when such a photosensitive microcell detects a photon and generates an electrical detection signal, such a microcell is no longer able to detect other photons until its polarization voltage is restored, either actively or passively. Since it takes some time for the polarization of a photosensitive microcell to be restored, when it detects a photon, the sensitivity of this sensor to the incidence of further photons is temporarily reduced until this microcell is restored. Furthermore, when a light radiation strikes the sensitive surface of such a sensor, the first photons of the radiation striking this surface are detected by almost all of the microcells of the sensor. This implies that, immediately after the detection of the first photons of a light radiation by an optical solid-state sensor of known type, the sensitivity of such a sensor to the incidence of further photons is greatly reduced. Even more disadvantageously, if the light radiation has a particularly high intensity, such a sensor could quickly run out of microcells capable of detecting other photons. In this case, the sensitivity of the sensor to the incidence of further photons would be completely nullified until at least one of the microcells is restored. This phenomenon, which produces a distortion in the detections of the light radiations by known solid-state optical sensors, is also called "pile-up distortion".

Devices for measuring a distance comprising such solid-state optical sensors of known type are also known. Such a device comprises emission means of a light radiation configured to emit such light radiation in the direction of a reference object. Said device also comprises at least one solid-state optical sensor configured to detect the incidence of one or more photons of said light radiation that are reflected from said reference object. Furthermore, said device also comprises an electronic board configured to control the emission of said light radiation by the emission means, acquire in input the electrical signals generated by said at least one optical sensor and determine the distance between a first point of said device and a second point of said reference object based on the acquired electrical signals. For this distance to be determined, the device measures the time interval, also known as Time of Flight (ToF), that elapses between the start of the emission of such radiation by the emission means and the detection of the same radiation by the optical sensors.

An important limit of this device for measuring a distance is again linked to the aforesaid phenomenon of "pile-up distortion", which concerns the solid-state optical sensors used. In fact, the detection of the radiation by such optical sensors is strongly influenced by the reflection coefficient of the surface of the reference object whose distance from the device is to be measured.

In particular, if the surface of the reference object is very reflective, for example due to a light colour of this surface, the phenomenon of "pile-up distortion" will make the totality of the optical sensors insensitive almost instantaneously. On the other hand, if the surface of the reference object is poorly reflective, e.g. due to a dark colour of that surface, the same distorting phenomenon will make the optical sensors insensitive much more slowly.

Thus, such a device for measuring a distance is subject to a measurement error linked to such a phenomenon.

The object of the present invention is to develop a solid-state optical sensor capable of obviating the aforesaid drawbacks and limitations of the prior art. In particular, an object of the present invention is to realize a solid-state optical sensor that is not affected by the "pile-up distortion" phenomenon during the step of detecting a light radiation. Still another object of the invention is to develop a device for measuring a distance, comprising such a solid-state optical sensor, which is not subject to a measurement error linked to the reflection coefficient of the surface of the reference object whose distance from the device is to be measured.

These objects are satisfied by an optical solid-state sensor according to claim 1, as well as by a device for measuring a distance according to claim 8 which comprises such an optical solid-state sensor.

Further features of the solid-state optical sensor according to claim 1 are described in the dependent claims.

The invention, together with the advantages that will be mentioned hereinafter, is highlighted by the description of an embodiment of the invention, which is given by way of non-limiting example with reference to the attached drawings, where:
- Fig. 1: represents a front view of a solid-state optical sensor according to the invention;
- Fig. 2: represents a sectional perspective view of a device for measuring a distance comprising the solid-state optical sensor of Figure 1;
- Figs. 3a, 3b and 3c: represent schematic views of the operation of the solid-state optical sensor of Figure 1;
- Figs. 4a, 4b, 4c and 4d: represent schematic views of the operation of an embodiment variant of an optical solid-state sensor according to the invention;
- Fig. 5a: represents a schematic view of the operation of an optical solid-state sensor with enablement made by a control unit;
- Fig. 5b: represents a schematic view of the operation of a solid-state optical sensor with "decentralized" enablement; and
- Fig. 5c: represents a schematic view of the operation of a solid-state optical sensor with "cyclic" enablement.

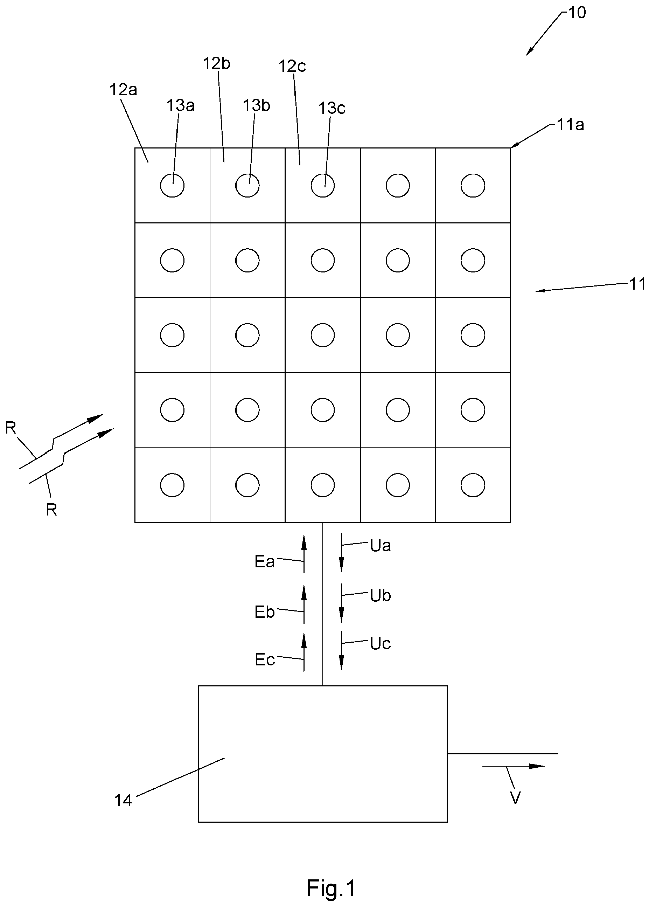

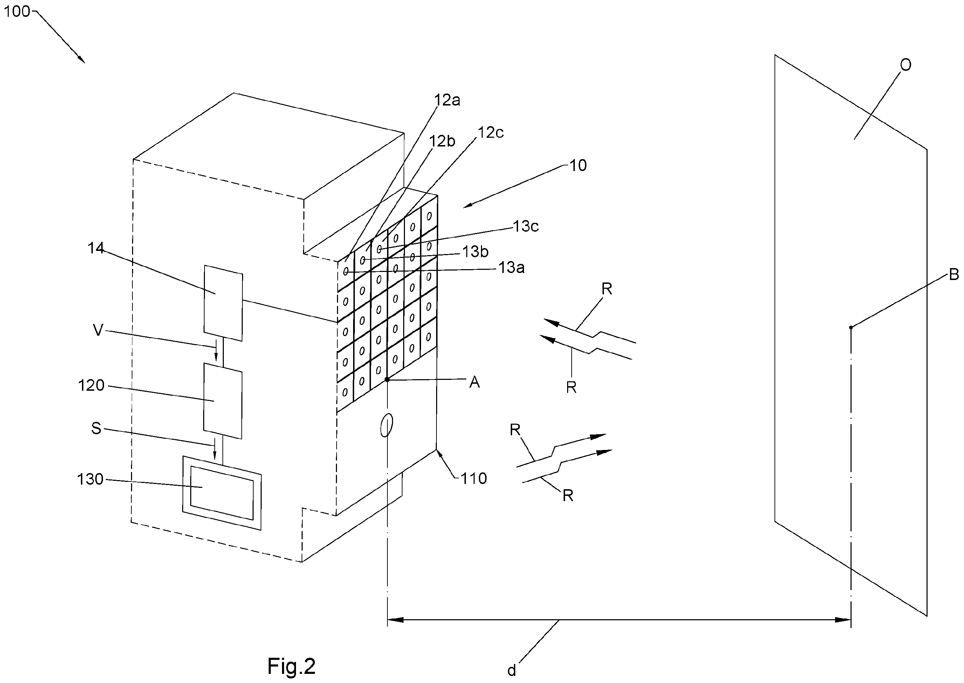

With reference to the aforesaid figures, an optical solid-state sensor according to the invention is indicated as a whole with the number **10**. This optical sensor **10**, clearly visible in figures 1 and 2, is configured to detect the incidence of one or more photons of a light radiation **R** during an acquisition window **Ta**. Said optical sensor **10** comprises a silicon plate **11**, also represented in figures 1 and 2.

Said silicon plate **11** comprises in turn a sensitive surface **11a** configured to detect the incidence of one or more photons of the light radiation **R** and on which a plurality of photosensitive microcells **12a, 12b, 12c** are obtained. Such a distribution of the photosensitive microcells **12a, 12b, 12c** on the sensitive surface **11a** according to a first embodiment example of the invention is clearly visible in Figures 1, 2, 3a, 3b and 3c.

In this embodiment of the invention, the photosensitive microcells **12a, 12b, 12c** are distributed on said sensitive surface **11a** with a matrix structure of five rows and five columns.

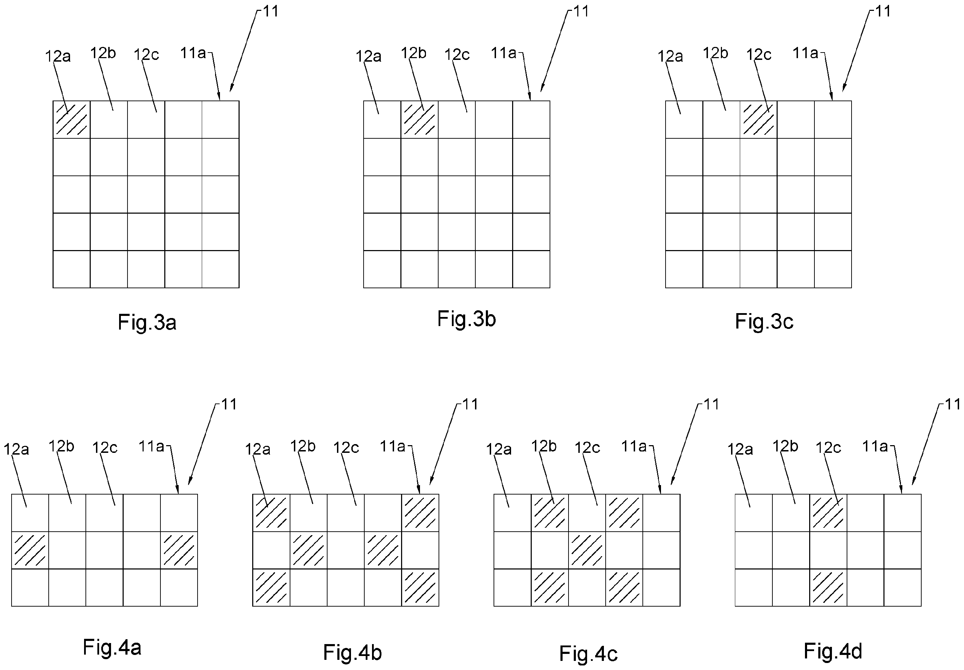

Figures 4a, 4b, 4c and 4d represent another distribution of the photosensitive microcells **12a, 12b, 12c** in a second embodiment of the invention. In this embodiment example, the photosensitive microcells **12a, 12b, 12c** are distributed on the sensitive surface **11a** with a matrix structure of three rows and five columns.

However, it cannot be ruled out that, in other embodiments of the invention, there is a different number of photosensitive microcells **12a, 12b, 12c** than previously described.

Each microcell of such a plurality of photosensitive microcells **12a, 12b, 12c** is adapted to respectively generate an electrical detection signal **Ua**, **Ub**, **Uc** when a photon is detected. Said optical sensor **10** also comprises a control unit **14**, clearly visible in figures 1 and 2, configured to acquire such electrical detection signals **Ua**, **Ub, Uc** in input. Furthermore, in these embodiment examples of the invention, such a control unit **14** is capable of processing such electrical detection signals **Ua**, **Ub**, **Uc** and is configured to generate at least one output electrical signal **V** obtained from a processing of such electrical detection signals **Ua, Ub, Uc**.

It is important to point out that the application of the correct polarization voltage to the ends of a photosensitive microcell of such a plurality of photosensitive microcells **12a, 12b, 12c** is a necessary but not sufficient condition for such a microcell to be considered "active". More precisely, in addition to the polarization voltage, an electrical enable signal **Ea, Eb, Ec** must also be applied in input to a photosensitive microcell for it to be defined as "active". Otherwise, a photosensitive microcell is to be considered "inactive" from the moment in which it generated an electrical detection signal **Ua, Ub, Uc,** until the conditions necessary for this microcell to be considered "active" are restored.

It is also important to point out that only the active microcells of such a plurality of photosensitive microcells **12a, 12b, 12c** are capable of detecting the incidence of a photon. Therefore, only such active microcells are capable of generating an electrical detection signal **Ua, Ub, Uc.** In contrast, the inactive microcells of said plurality of photosensitive microcells **12a**, **12b**, **12c** are unable to detect the incidence of a photon and thus generate an electrical detection signal **Ua**, **Ub**, **Uc**.

The optical sensor **10**, according to the invention, is configured to perform the following operating steps:
a) activating at least one microcell of the plurality of photosensitive microcells **12a**, **12b**, **12c** at the beginning of the acquisition window **Ta** while keeping the remaining microcells inactive;
b) waiting for the generation of one of the electrical detection signals **Ua, Ub, Uc** by said at least one active microcell;
c) activating at least one different inactive microcell by means of said electrical enable signal **Ea**, **Eb**, **Ec** when one of said electrical detection signals **Ua, Ub, Uc** has been generated;
d) repeating steps b) and c) for the duration of the acquisition window **Ta**.

In the aforesaid first embodiment example of the invention, schematically represented in Figure 3a, at the beginning of the acquisition window **Ta,** only one microcell **12a** is active, while the remaining microcells are kept inactive by the optical sensor **10.** After activating the microcell **12a,** the optical sensor **10** waits for said microcell **12a** to detect a photon and then to generate the corresponding electrical detection signal **Ua.** When this electrical detection signal Ua is generated by the microcell **12a,** the microcell **12a** will be inactive, while the microcell **12b** will be activated by the optical sensor **10.** After activation of the microcell **12b,** schematically represented in Figure 3b, the optical sensor **10** waits for said microcell **12b** to detect a photon and then to generate the corresponding electrical detection signal Ub. When such an electrical detection signal **Ub** is generated by the microcell **12b,** the microcell **12b** will be inactive, while a different inactive microcell will be activated by the optical sensor **10,** for example **12c** as represented in Figure 3c.

In the aforesaid second embodiment example, schematised at the beginning of the acquisition window **Ta** in Figure 4a, two photosensitive microcells are active, while the remaining microcells are kept inactive by the optical sensor **10.** Like in the previous schematisations of Figure 3a, 3b and 3c, the active microcells are identified with an internal hatch. When an electrical detection signal is generated by the active microcells, these active microcells will then be inactive, while a combination of microcells will be activated by the optical sensor **10,** for example according to the schematisation of figure 4b. The light radiation detection procedure **R** then continues as schematised in Figure 4c and 4d.

This first embodiment example shows how an optical sensor **10** according to the invention solves the problem related to the "pile-up distortion" phenomenon, since only a part of the plurality of photosensitive microcells **12a, 12b, 12c** of said optical sensor 10 is active at each instant of the acquisition window **Ta.**

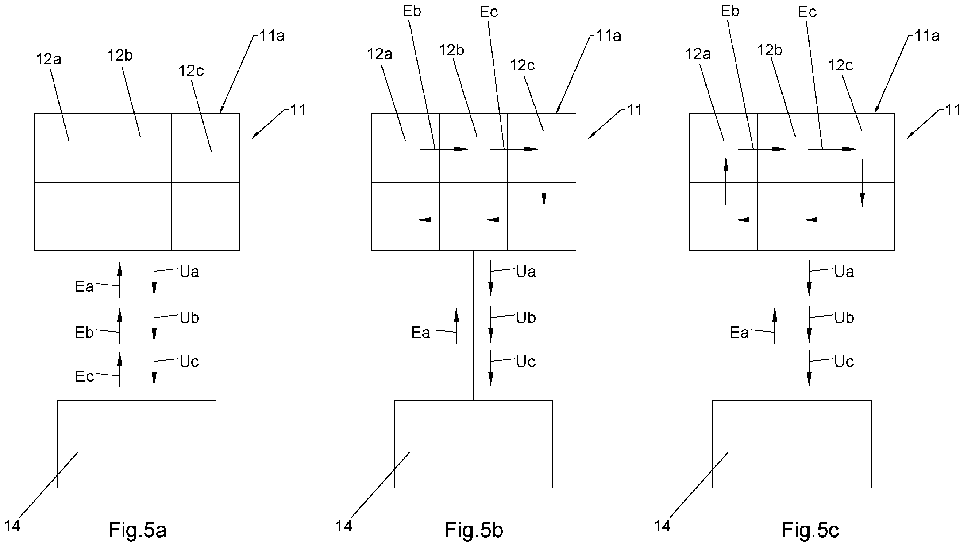

In particular, according to a first embodiment of the optical sensor **10** according to the invention, represented in figure 5a, the enablement of the microcells is carried out by the control unit **14** which is capable of controlling the instant of activation of each of said plurality of photosensitive microcells **12a, 12b, 12c** by means of the electrical enable signal **Ea, Eb, Ec.** This means that, following the generation of one of the electrical detection signals **Ua, Ub, Uc** by an active microcell, the control unit **14** will activate a different inactive microcell by means of an electrical enable signal **Ea, Eb, Ec.**

In a different embodiment of the invention, represented in Figure 5b, the control unit **14** is capable of controlling the instant of activation of at least one of such plurality of photosensitive microcells **12a, 12b, 12c** by means of the electrical enable signal **Ea, Eb, Ec.** Further, at least one first photosensitive microcell of such a plurality of photosensitive microcells **12a, 12b, 12c** is connected in series to at least one second photosensitive microcell. This allows to obtain a "decentralized" enablement of the microcells, allowing the control of the instant of activation of said at least one second photosensitive microcell by said first photosensitive microcell by generating one of the aforesaid electrical detection signals **Ua, Ub, Uc.** Therefore, these electrical detection **Ua, Ub, Uc,** as can be clearly seen from Figure 5b, also act as electrical enable signals **Ea, Eb, Ec,** being directly responsible for the activation of inactive microcells.

A variant of the latter embodiment of the invention still provides that each of said photosensitive microcells is connected in series to at least one different photosensitive microcell, as represented in Figure 5c. This allows to obtain a "cyclic" enablement of the photosensitive microcells that does not limit the acquisition window **Ta** to a single activation of each microcell, allowing the last microcell of the series to control the instant of activation of the first microcell in the series. In particular, the last microcell of the series, in conjunction with the generation of the corresponding electrical detection signal, will generate an electrical enable signal **Ea'** enabling the microcell **12a** again.

In one embodiment of the invention, after the generation of an electrical detection signal, for example **Ua,** the activation of a different inactive microcell, for example **12b,** takes place after a latency time **Td.** This latency time **Td** allows to extend the duration of the acquisition window **Ta** and adapt this window to the time duration of the light radiation **R** that is to be detected.

However, it is not excluded that according to a variant of such an embodiment of the invention, after the generation of an electrical detection signal, for example **Ua,** the activation of a different inactive microcell, for example **12b,** takes place almost instantaneously.

Each microcell of such a plurality of photosensitive microcells **12a, 12b, 12c** comprises a Single-Photon Avalanche Diode (SPAD), respectively **13a, 13b** and **13c,** as represented in Figures 1 and 2. Each microcell of such a plurality of photosensitive microcells **12a, 12b, 12c** is thus adapted to generate an electrical detection signal **Ua, Ub, Uc** when a photon is detected by the respective Single-Photon Avalanche Diode **13a, 13b** and **13c.**

Other embodiments of the invention, not represented for simplicity's sake, involve the use of a plurality of Single-Photon Avalanche Diodes in each microcell. In this case, the sensitivity of each photosensitive microcell **12a, 12b, 12c** will be higher than the sensitivity of microcells comprising a Single-Photon Avalanche Diode.

A device for measuring **100** a distance **d,** clearly visible in Figure 2, comprising at least one optical sensor **10** as described above, is also an object of the invention. In particular, said measuring device **100** comprises emission means **110,** visible in figure 2, of a light radiation **R** configured to emit said light radiation **R** with a duration equal to an emission window **Te** in the direction of a reference object **O.** In the present embodiment example of the invention, such emission means **110** comprise a laser emitter.

Furthermore, said measuring device **100** also comprises at least one solid-state optical sensor **10,** also visible in Figure 2, configured to detect the incidence of one or more photons of said light radiation **R** that are reflected by said reference object **O** in the direction of said at least one optical sensor **10** during an acquisition window **Ta.** In the first embodiment of the invention described herein, such a measuring device **100** comprises a single optical sensor **10.** However, the use of a plurality of optical sensors **10** cannot be excluded in other embodiments of the invention.

Again in the present embodiment example of the invention, the sum of the latency times **Td** between the operating steps b) and the operating steps d) applied by said optical sensor **10** during the emission window **Te** is greater than or equal to the emission window **Te.** This ensures that the acquisition window **Ta** of the optical sensor **10** is at least equal to, if not greater than, the emission window **Te** of the emission means **110.** In this way, the information contained in the light radiation **R**that is to be detected will be completely acquired by the measuring device **100.** This information can then be used by the measuring device **100** to make a more accurate estimate of the ToF of the light radiation **R,** and therefore of the distance **d** that is to be measured.

The measuring device **100** also comprises an electronic board **120,** still visible in figure 2, configured to control the emission of such light radiation **R** with a duration equal to the emission window **Te** by the emission means **110.** Said electronic board **120** is arranged to acquire in input at least one electrical signal generated by said optical sensor **10** during the acquisition window **Ta.** Further, the electronic board **120** is configured to determine the distance between a first point **A** of said measuring device **100** and a second point **B** of the reference object **O** based on said at least one electrical signal.

In the present embodiment example of the invention, the electronic board **120** is adapted to generate at least one electrical measurement signal **S** relative to the measured distance **d.**

The measuring device **100** further comprises interfacing means **130,** clearly visible in figure 2, configured to allow the initiation of a measurement of said distance **d.** In addition, said interfacing means **130** are also configured to allow the measured value of said distance **d** to be displayed. In particular, in the embodiment of the invention described herein, the interfacing means comprise a touch screen control panel through which a user can initiate a measurement of the distance **d** and display said measured value of the distance **d.**

It has in practice been established that the invention achieves the intended task and objects. In particular, with the invention, a solid-state optical sensor has been developed that is not affected by the "pile-up distortion" phenomenon during the step of detecting a light radiation. In addition, with the invention a device for measuring a distance has been developed, comprising such a solid-state optical sensor, which is not subject to a measurement error linked to the reflection coefficient of the surface of the reference object whose distance from the device is to be measured.

The invention thus conceived is susceptible to many modifications and variants, all falling within the same inventive concept; furthermore, all details can be replaced by equivalent technical elements. In practice, the components and the materials used could be of any type, so long as they are compatible with the specific use, as well as the contingent shapes and dimensions, according to requirements and the state of the art.

Where the features and techniques mentioned in any claim are followed by reference marks, such reference marks are intended to be affixed solely for the purpose of increasing the intelligibility of the claims and consequently such reference marks have no limiting effect on the interpretation of each element identified by way of example by such reference marks.

## Claims

1. Solid-state optical sensor (10) configured to detect the incidence of one or more photons of a light radiation (R) during an acquisition window (Ta), said optical sensor (10) comprising:
- a silicon plate (11) comprising a sensitive surface (11a), said sensitive surface (11a) being configured to detect the incidence of one or more photons of said light radiation (R), said sensitive surface (11) comprising a plurality of photosensitive microcells (12a, 12b, 12c), each microcell of said plurality of photosensitive microcells (12a, 12b, 12c) being adapted to generate respectively an electrical detection signal (Ua, Ub, Uc) when a photon is detected;
- a control unit (14) configured to acquire said electrical detection signals (Ua, Ub, Uc) in input;
**characterized in that** said optical sensor (10) is configured to perform the following operating steps:
a) activating at least one microcell of said plurality of photosensitive microcells (12a, 12b, 12c) at the beginning of said acquisition window (Ta) while keeping the remaining microcells inactive;
b) waiting for the generation of one of said electrical detection signals (Ua, Ub, Uc) by said at least one active microcell;
c) activating at least one different inactive microcell by means of an electrical enable signal (Ea, Eb, Ec) when one of said electrical detection signals (Ua, Ub, Uc) has been generated;
d) repeating steps b) and c) for the duration of said acquisition window (Ta).

2. Optical sensor (10) according to claim 1, **characterized in that** said control unit (14) is capable of controlling the instant of activation of each of said plurality of photosensitive microcells (12a, 12b, 12c) by means of said electrical enable signal (Ea, Eb, Ec).

3. Optical sensor (10) according to claim 1, **characterized in that** said control unit (14) is capable of controlling the instant of activation of at least one of said plurality of photosensitive microcells (12a, 12b, 12c) by means of said electrical enable signal (Ea, Eb, Ec), at least a first photosensitive microcell of said plurality of photosensitive microcells (12a, 12b, 12c) being connected in series to at least a second photosensitive microcell of said plurality of photosensitive microcells (12a, 12b, 12c), the instant of activation of said at least a second photosensitive microcell of said plurality of photosensitive microcells (12a, 12b, 12c) being controlled directly by said first photosensitive microcell of said plurality of photosensitive microcells (12a, 12b, 12c) by generating one of said electrical detection signals (Ua, Ub, Uc).

4. Optical sensor (10) according to claim 3, **characterized in that** each of said photosensitive microcells of said plurality of photosensitive microcells (12a, 12b, 12c) is connected in series to at least one different photosensitive microcell of said plurality of photosensitive microcells (12a, 12b, 12c).

5. Optical sensor (10) according to any one of the preceding claims, **characterized in that** a latency time (Td) is applied between said operating step b) and said operating step c).

6. Optical sensor (10) according to any one of the preceding claims, **characterized in that** each microcell of said plurality of photosensitive microcells (12a, 12b, 12c) comprises at least one single-photon avalanche diode (13a, 13b, 13c), each of said plurality of photosensitive microcells (12a, 12b, 12c) being adapted to generate one of said electrical detection signals (Ua, Ub, Uc) when a photon is detected by said at least one single-photon avalanche diode (13a, 13b, 13c).

7. Optical sensor (10) according to any one of the preceding claims, **characterized in that** said control unit (14) is capable of processing said electrical detection signals (Ua, Ub, Uc), said control unit (14) being configured to generate at least one electrical output signal (V) obtained by processing said electrical detection signals (Ua, Ub, Uc).

8. Device for measuring (100) a distance (d) comprising:
- emission means (110) of a light radiation (R) configured to emit said light radiation (R) with a duration equal to an emission window (Te) in the direction of a reference object (O);
- at least one solid-state optical sensor (10) configured to detect the incidence of one or more photons of said light radiation (R) reflected from said reference object (O) in the direction of said at least one optical sensor (10) during an acquisition window (Ta);
- an electronic board (120) configured to control the emission of said light radiation (R) having a duration equal to said emission window (Te) by said emission means (110), said electronic board (120) being configured to acquire in input at least one electrical signal generated by said at least one optical sensor (10) during said acquisition window (Ta), said electronic board (120) being configured to determine the distance between a first point (A) of said measuring device (100) and a second point (B) of said reference object (O) based on said at least one electrical signal, **characterized in that** said at least one optical sensor (10) is an optical sensor (10) according to any one of claims 1 to 8.

9. Measuring device (100) according to claim 8 in combination with claim 5, **characterized in that** the sum of the latency times (Td) between said operating steps b) and said operating steps d) applied by said at least one optical sensor (10) during said acquisition window (Ta) is greater than or equal to said emission window (Te).

10. Measuring device (100) according to claim 8 or 9, **characterized in that** said electronic board (120) is configured to generate at least one electrical measuring signal (S) relative to the measured distance (d).

11. Measuring device (100) according to any one of claims 8 to 10, **characterized by** comprising interfacing means (130), said interfacing means (130) being configured to enable the initiation of a measurement of said distance (d).

12. Measuring device (100) according to claim 11, **characterized in that** said interfacing means (130) are configured to allow the measured value of said distance (d) to be displayed.
